# FASCICULE DE BREVET EUROPEEN

(11) **EP 2 559 053 B1**
(45) Date de publication et mention de la délivrance du brevet: **27.06.2018**
(21) Numéro de dépôt: 11714290.1
(22) Date de dépôt: 13.04.2011
(51) Int. Cl.: H01J 37/317

(54) **PROCEDE DE LITHOGRAPHIE ELECTRONIQUE PAR PROJECTION DE CELLULES A GRANDE MAILLE**
ELEKTRONENSTRAHLLITHOGRAFIEVERFAHREN MIT GROSSMASCHIGER ZELLENPROJEKTION
LARGE-MESH CELL- PROJECTION ELECTRON-BEAM LITHOGRAPHY METHOD

(30) Priorité: 15.04.2010 FR 1052866
(43) Date de publication de la demande: 20.02.2013
(73) Titulaire: Commissariat à l'Énergie Atomique et aux Énergies Alternatives, 75015 Paris (FR)
(72) Inventeur: MANAKLI, Serdar, F-38300 Meyrie (FR)
(74) Mandataire: Priori, Enrico
(86) Numéro de dépôt international: PCT/EP2011/055861
(87) Numéro de publication internationale: WO 2011/128391

(56) Documents cités:
- US-A- 5 808 310
- US-A- 6 069 684
- US-A1- 2002 153 494
- US-A1- 2010 058 279

## Description

La présente invention s'applique au domaine de la lithographie électronique. Pour permettre la gravure de motifs dont la dimension critique est inférieure à 50nm, il faut intégrer dans les procédés de photolithographie optique des méthodes de correction des distorsions optiques de plus en plus complexes à la fois au stade de la conception et de la production des masques et au stade de l'exposition. Les coûts des équipements et des développements pour une nouvelle génération de technologie augmentent en conséquence dans des proportions très élevées. Aujourd'hui, les dimensions critiques accessibles en photolithographie sont supérieures ou égales à 65 nm. La génération 32-45 nm est en cours de développement et il n'existe pas de solution viable envisagée pour les noeuds technologiques inférieurs à 22 nm. De son côté, la lithographie électronique permet dores et déjà la gravure de motifs de 22 nm ; elle ne nécessite pas de masque et offre un temps de développement assez court, ce qui permet une meilleure réactivité et flexibilité dans la réalisation d'améliorations aux technologies et aux designs. En revanche, les temps de production sont structurellement sensiblement plus élevés qu'en photolithographie puisqu'il faut réaliser une exposition par pas (avec un « stepper »), alors que la photolithographie ne nécessite qu'une exposition par couche. Pour les design à motifs répétitifs tels que circuits mémoires et les mers de portes (gate arrays), on a développé une technologie de projection de cellule dans laquelle un motif complet (ou cellule) est gravé en un seul shot. Une méthode de cette nature est décrite dans le brevet US 5,808,310. Une autre solution est proposée par le brevet US6069684.

Dans cette technologie de projection de cellule, le technologue se pose inlassablement le problème de réduire le temps d'écriture et donc le nombre et la durée des shots pour réduire le temps et le coût de production d'un composant.

La présente invention apporte une réponse à ce problème en agrandissant le maillage de cellules et en réduisant corrélativement les doses rayonnées, ce qui permet de réduire le temps d'écriture. De cette manière également, il est possible de prévoir un dosage uniforme sur toute la surface du bloc à graver, sauf dans le voisinage de ses bords. Avantageusement, dans une technologie de 22 nm de dimension critique, une cellule de 2,4 µm² procure une réduction du nombre de shots, et donc du temps de production, d'un facteur proche de 4.

A cet effet, l'invention prévoit un procédé de lithographie rayonnante selon la revendication 1. Avantageusement, au moins une rangée de cellules élémentaires est implantée à l'extérieur des bords dudit bloc à graver.

Avantageusement, les cellules élémentaires non situées dans le voisinage des bords du bloc à graver sont non jointives.

Avantageusement, le procédé de l'invention comprend en outre une étape de calcul de la largeur de shots à implanter à l'extérieur d'un bord de bloc, une étape de calcul de modulation de dose sur les bords dudit bloc, lesdits calculs étant liés par une relation fonctionnelle faisant intervenir la latitude en énergie du procédé, et une étape d'implantation desdits shots à l'extérieur dudit bloc.

Avantageusement, l'étape de calcul de modulation de dose sur les bords dudit bloc comprend une sous-étape de calcul de ladite dose par convolution de la dose rayonnée avec le motif du bord.

Avantageusement, l'étape de calcul de modulation de dose sur les bords dudit bloc comprend une sous-étape de calcul de ladite dose par appel d'une table de paramètres.

Avantageusement, le procédé de l'invention comprend en outre une étape de calcul d'au moins un espacement entre le bord du bloc et les shots à implanter à l'extérieur dudit bloc.

Avantageusement, la taille du bloc à graver est égale à 500nm.

Pour mettre en oeuvre le procédé, l'invention prévoit également un programme d'ordinateur selon la revendication 10. Avantageusement, le programme d'ordinateur de l'invention comprend en outre un module apte à effectuer le calcul de la largeur de shots à implanter à l'extérieur d'un bord de bloc et le calcul de modulation de dose sur les bords dudit bloc, lesdits calculs étant liés par une relation fonctionnelle faisant intervenir la latitude en énergie du procédé, et un module apte à réaliser l'implantation desdits shots à l'extérieur dudit bloc.

Avantageusement, le programme d'ordinateur de l'invention comprend en outre un module apte à effectuer le calcul d'au moins un espacement entre le bord du bloc et les shots à implanter à l'extérieur dudit bloc.

L'invention permet également de réduire le nombre de doses élevées (et donc le nombre de shots de longue durée). Globalement, elle procure donc une réduction cumulative des temps de production. L'invention est en outre particulièrement avantageuse lorsqu'elle est appliquée sur un design à tous les blocs de plus de 5 µm de largeur, à tous les blocs opaques et aux blocs d'entrées/sorties.

L'invention sera mieux comprise, ses différentes caractéristiques et avantages ressortiront de la description qui suit de plusieurs exemples de réalisation et de ses figures annexées dont :
- Les figures 1a, 1b et 1c représentent respectivement les deux niveaux d'un dispositif de lithographie électronique, l'illustration de leur superposition et divers résultats de ladite superposition;
- La figure 2 représente de manière graphique la dose rayonnée par un dispositif de lithographie électronique en fonction de la dimension critique du design pour quatre types de motifs à graver ;
- La figure 3 représente la manière dont est gravée une cellule dans un mode de réalisation de l'invention ;
- Les figures 4a et 4b représentent respectivement un ensemble de blocs à graver et cet ensemble gravé par un procédé de l'art antérieur;
- Les figures 5a et 5b représentent respectivement une vue du niveau de cellules factices à graver et cet ensemble gravé par un procédé selon un mode de réalisation de l'invention ;
- Les figures 6a et 6b représentent respectivement une vue du niveau de cellules à graver et cet ensemble gravé par un procédé de selon une variante de l'invention ;
- La figure 7 illustre le procédé de resizing des bords du bloc à graver;
- La figure 8 illustre un mode de réalisation de l'invention dans lequel les cellules à graver ne sont pas jointives.

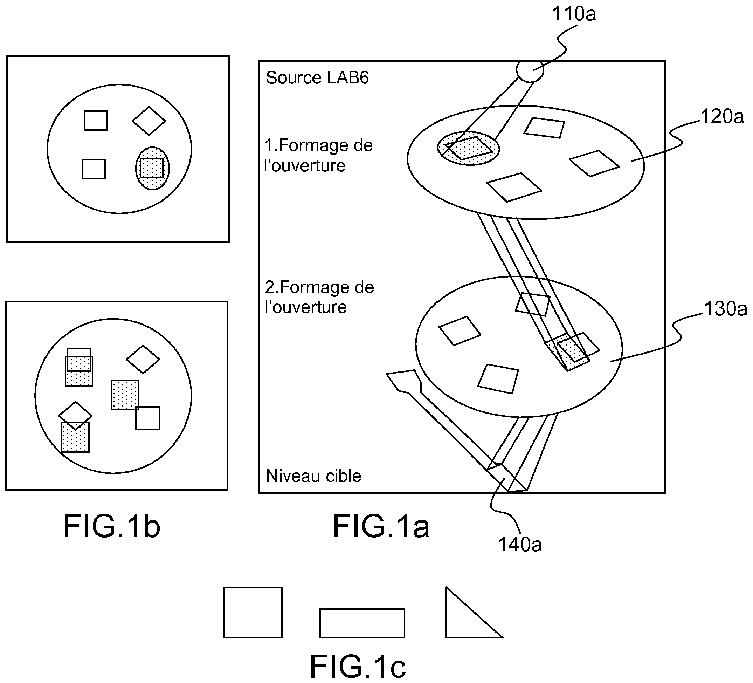

Les figures 1a, 1b et 1c représentent respectivement les deux niveaux d'un dispositif de lithographie électronique, l'illustration de leur superposition et divers résultats de ladite superposition.

Dans un dispositif classique de lithographie électronique, le motif à graver est d'abord fracturé en cellules fonctionnelles élémentaires, 140a, aptes à être gravées sur un substrat résiné. Ledit substrat résiné peut être un wafer en silicium, en un autre matériau III-V ou en verre, sur lequel les fonctions d'un circuit électronique sont destinées à être gravées par écriture rayonnante directe, ledit rayonnement pouvant être un rayonnement électronique ou un rayonnement ionique. Ledit substrat peut également être un masque qui sera ensuite utilisé pour graver un wafer constitué des mêmes matériaux que ci-dessus, ladite gravure utilisant un procédé de gravure électronique ou ionique ou un procédé de lithographie optique. Dans la suite de la description, le procédé de l'invention sera illustré par des exemples de réalisation selon un procédé de lithographie électronique par écriture directe sur un wafer de nature quelconque, sans que ces exemples puissent être considérés comme limitatifs du champ d'application complet de l'invention. Le procédé de l'invention est particulièrement adapté à la reproduction de blocs fonctionnels à motifs répétitifs tels que des mémoires dynamiques, statiques, vives ou mortes, réinscriptibles ou non réinscriptibles, ainsi qu'à des circuits du type mers de portes (gate arrays).

Une machine apte à réaliser le procédé de l'invention après des adaptations de son logiciel de pilotage et/ou d'au moins un des supports de stencils, qui sont explicitées dans la suite de la description est par exemple une machine de marque VISTEC™ ou ADVANTEST™.

Dans un tel procédé servant d'exemple de réalisation, une source d'électrons, 110a, rayonne sur le substrat par l'intermédiaire de deux niveaux de stencils, 120a et 130a, qui comportent des figures élémentaires telles que des carrés, des rectangles ou des triangles, représentés sur la figure 1c.

Les figures élémentaires des deux niveaux de stencils, 120a et 130a, sont composées entre elles, de telle sorte que les dimensions de la cellule élémentaire qui sera gravée sur le substrat, 140a, correspondent au design recherché. La composition des deux stencils est effectuée de manière connue de l'homme de l'art. Un logiciel configuré à cet effet pilote la rotation des supports des stencils pour que les figures élémentaires des deux stencils soient correctement alignées au moment de l'émission du shot par la source d'électrons, 110a.

Selon l'invention, la maille d'une cellule élémentaire 140a qui est gravée sur le substrat est choisie la plus grande possible en fonction des paramètres de la machine utilisée tels que garantis par le constructeur pour une résolution optimale sur des motifs. Ainsi lorsque la résolution de la machine de lithographie est garantie par le constructeur pour une maille de 1,6 µm x 1,6 µm, ce qui correspond à une technologie de dimension critique de 45 et 32 nm, il est possible d'utiliser une maille d'environ 2,4 µm x 2,4 µm pour des motifs à graver qui ne comportent pas de lignes à haute résolution. Il s'agit de l'ouverture maximale de la machine, qui est utilisable sans perte de résolution dans le cas de ces applications. On obtient ainsi une augmentation de 125% de la superficie de la maille moyenne des cellules au milieu du motif, soit une division par deux environ du nombre de shots et donc du temps d'exposition.. Malgré ses avantages, l'augmentation de la taille des cellules n'est pas une idée qui vient naturellement à l'esprit de l'homme du métier dont la priorité est l'amélioration de la résolution. Il en est même dissuadé par les fabricants de machines qui imposent normalement un réglage de l'ouverture maximale permettant l'utilisation sans modification du réglage de la machine pour tous types de motifs, notamment à haute résolution. Ainsi, Vistec garantit ses performances pour une maille de 1,6 x 1,6 µm au maximum, alors qu'il est possible d'utiliser avantageusement des shots de taille bien plus grande (2,4 µm x 2,4 µm). On peut envisager d'aller encore au-delà avec d'autres machines.

On notera qu'une modification de l'ouverture sur le premier stencil impose une procédure de réglage complexe, ce qui dissuade d'effectuer une telle modification. En revanche, comme préconisé pour mettre en oeuvre l'invention, il est possible de modifier l'ouverture sur le 2^{ème} stencil sans réglage des paramètres machine.

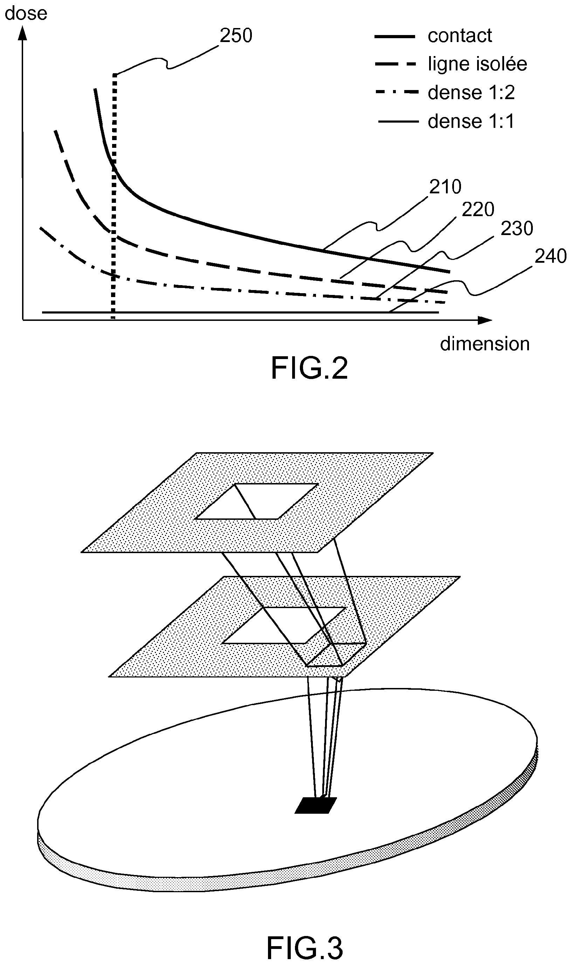

La figure 2 représente de manière graphique la dose rayonnée par un dispositif de lithographie électronique en fonction de la dimension du design pour quatre types de motifs à graver.

Les quatre courbes, 210, 220, 230 et 240 représentent les évolutions de doses nécessaires pour graver des motifs en fonction de leur dimension dans quatre cas, respectivement :
- Une 1^{ère} ligne insérée dans un réseau dense où les lignes et les espaces ont des largeurs égales (1 :1);
- Une 2^{ème} ligne insérée dans un réseau semi-dense où les espaces ont une largeur égale à deux fois celle des lignes (1 :2);
- Une ligne isolée ;
- Un ensemble de points de contact.

La droite verticale, 250, représente la dimension critique du procédé.

La figure 3 représente la manière dont est gravée une cellule dans un mode de réalisation de l'invention.

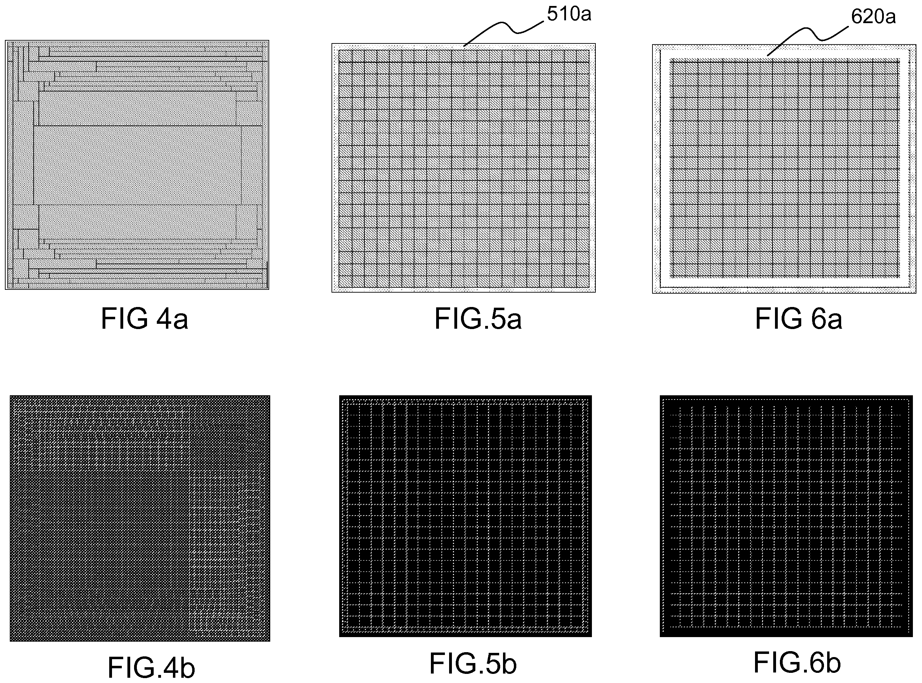

Les deux niveaux de stencil 120a et 130a doivent être positionnés l'un part rapport à l'autre de manière dynamique de telle manière que la source d'électrons, 110a, puisse combiner les deux ouvertures de ces stencils pour graver sur le substrat une cellule 140a de maille moyenne de 2,4 µm x 2,4 µm. Les figures 4a et 4b représentent respectivement un ensemble de blocs à graver et cet ensemble gravé par un procédé de l'art antérieur.

La figure 4a représente le bloc à graver après fracturation. La figure 4b représente le bloc gravé.

Les figures 5a et 5b représentent respectivement une vue du niveau de cellules à graver et cet ensemble gravé par un procédé selon un mode de réalisation de l'invention.

La figure 5a représente le bloc à graver après fracturation. On note sur le bord, une bande 510a qui représente une dose rayonnée ajoutée à l'extérieur du motif à graver. On laisse un espace entre le motif à graver et la bande rajoutée et, éventuellement, on ajoute au moins une deuxième bande extérieure séparée également de la première par un espace. Dans toutes les configurations, cet espacement améliore la latitude en énergie du procédé. Expérimentalement, on constate qu'un espacement compris entre 0,2 fois la largeur de bande et 3 fois la largeur de bande est efficace. selon le procédé divulgué par la demande de brevet déposée par la demanderesse de la présente demande sous le numéro 1052862.

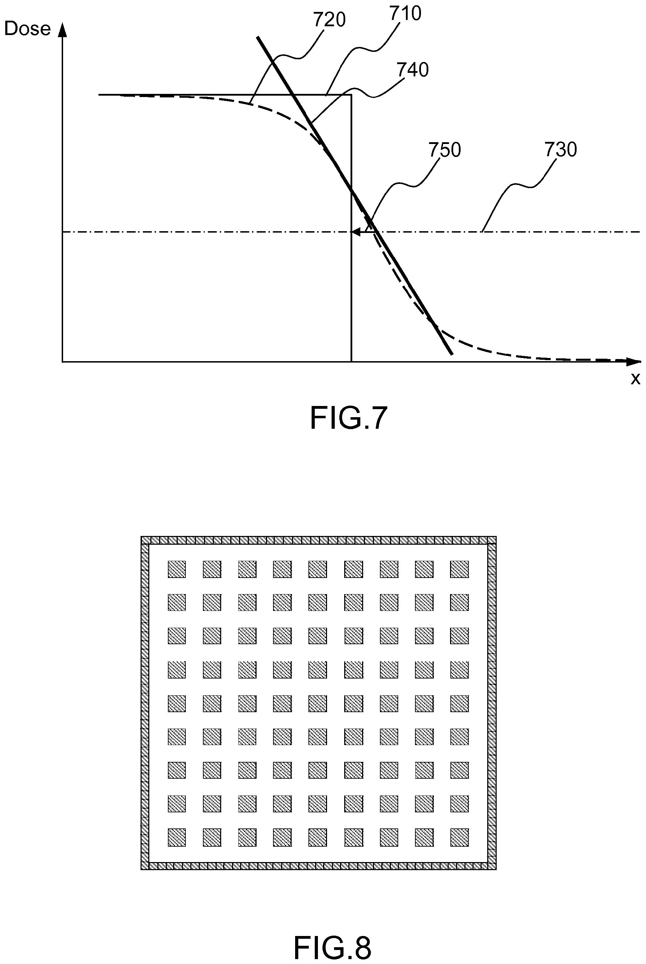

Dans le procédé décrit par cette demande de brevet, qui vise une correction des effets de proximité inhérents aux procédés de lithographie pour les géométries inférieures à 50 nm, on calcule la dose à appliquer à l'extérieur du motif soit par convolution de la dose rayonnée avec le motif à graver soit en utilisant une table de paramètres. Le calcul combiné de la modulation de dose à appliquer et de la taille du motif nouveau est effectué de manière à préserver la latitude en énergie du procédé selon un calcul dont un exemple est donné ci-dessous en commentaire à la figure 7.

La figure 5b représente le bloc gravé. La comparaison visuelle des figures 4b et 5b permet de constater la diminution très importante du nombre de cellules et donc du temps d'exposition qui résulte de l'utilisation du procédé de l'invention.

On observe également une caractéristique importante de l'invention selon laquelle le dosage de l'énergie rayonnées est uniforme sur toutes les cellules élémentaires formées, sauf dans les voisinage des bords (à l'intérieur ou à l'extérieur du bloc à graver).

Une des difficultés liées à l'utilisation du procédé de l'invention est le contrôle de l'ouverture sur le premier stencil. En effet, cette procédure suppose en règle générale un setup complet. En revanche, le redimensionnement des motifs sur le deuxième stencil permet d'obtenir une augmentation de l'ouverture sans avoir à effectuer ce setup. Cette variante de réalisation est donc particulièrement avantageuse.

Les figures 6a et 6b représentent respectivement une vue du niveau de cellules à graver et cet ensemble gravé par un procédé de selon une autre variante de l'invention.

Sur la figure 6a, on observe un espacement, 620a, entre la bande ajoutée à l'extérieur du motif, 510a, de la figure 5a et le motif à graver. Cet espacement permet d'optimiser la latitude en énergie du procédé. Un autre mode de réalisation avantageux consiste à laisser un espace entre le motif à graver et la bande rajoutée et, à ajouter au moins une deuxième bande extérieure séparée également de la première par un espace. Dans toutes les configurations, cet espacement améliore la latitude en énergie du procédé. Expérimentalement, on constate qu'un espacement compris entre 0,2 fois la largeur de bande et 3 fois la largeur de bande est efficace.

Le calcul du positionnement de la bande supplémentaire 510a est illustré par la figure 7 dans un mode de réalisation où la modulation de dose est calculée à partir d'une convolution de la dose rayonnée avec le motif à graver.

La géométrie du motif additionnel est ensuite modifiée dans au moins une dimension pour optimiser la latitude en énergie du procédé. Plus précisément, on calcule le déplacement, 750, à effectuer selon cette dimension en recherchant l'intersection de la droite, 740, tangente à la courbe de dose reçue, 720, au point où la dose reçue est égale au seuil de sensibilité de la résine à 0,5 avec la droite, 730, qui matérialise ledit seuil de sensibilité, puis en effectuant le déplacement vers le point d'intersection de cette dernière droite avec le profil de la dose rayonnée, 710.

Le calcul combiné dose/motifs peut être itéré deux ou trois fois.

La modulation de la dose à appliquer sur les motifs peut également être calculée à partir d'une table de paramètres sans calcul de convolution, notamment lorsque la modulation n'est appliquée que sur les shots extérieurs aux motifs, les autres shots étant appliqués à la valeur normalisée du procédé, ou à une valeur inférieure de l'ordre de 30% à celle-ci.

La figure 8 illustre un mode de réalisation de l'invention dans lequel les cellules à graver ne sont pas jointives.

Dans cet exemple de réalisation, les cellules élémentaires sont disposées de manière non jointive. En effet, les cellules ne sont pas nécessairement juxtaposées. Elles peuvent être avantageusement séparées les unes des autres. Dans la mesure où le temps d'écriture est relié au produit (surface à insoler x dose), il est possible, dans certaines configurations, de trouver un bon compromis en ne juxtaposant pas les cellules. On notera que l'exemple illustré par la figure 8 n'est nullement limitatif et que l'espacement entre zones exposées n'est pas nécessairement égal à leur taille.

La méthode de l'invention a été décrite dans un exemple d'application à un procédé de lithographie électronique par écriture directe. Elle peut également être appliquée à un autre procédé d'écriture directe utilisant d'autres particules telles que des ions ou des photons ou à des procédés de lithographie électronique ou à un procédé d'écriture optique utilisant des masques. Le champ de l'invention est défini par les revendications qui suivent.

## Revendications

1. Procédé de lithographie électronique par projection d'au moins un bloc sur un substrat résiné comprenant une étape de fracturation dudit bloc en cellules élémentaires (140a) à projeter sur ledit substrat et une étape de formage desdites cellules par une source rayonnante (110a), ledit procédé étant **caractérisé en ce que** la maille desdites cellules élémentaires (140a) est supérieure d'environ 125% à la maille normale des cellules du procédé, la maille normale des cellules du procédé étant d'environ 1,6 µm x 1,6 µm pour la génération de technologie 32-45 nm et **en ce que** le dosage de l'énergie rayonnée a une première valeur uniforme pour toutes les cellules élémentaires dudit au moins un bloc, sauf dans le voisinage des bords dudit bloc et une deuxième valeur uniforme, différente de la première valeur uniforme, pour une première bande située à l'extérieur dudit bloc et séparée de lui par un espace.

2. Procédé de lithographie selon la revendication 1, **caractérisé en ce que** la deuxième valeur uniforme est appliquée à une deuxième bande séparée de la première bande par un espace.

3. Procédé de lithographie selon l'une quelconque des revendications 1 à 2, **caractérisé en ce que** au moins une rangée de cellules élémentaires est implantée à l'extérieur des bords dudit bloc à graver.

4. Procédé de lithographie selon l'une quelconque des revendications 1 à 3, **caractérisé en ce que** les cellules élémentaires non situées dans le voisinage des bords du bloc à graver sont non jointives.

5. Procédé de lithographie selon l'une quelconque des revendications 1 à 4, **caractérisé en ce qu'**il comprend en outre une étape de calcul de la largeur de shots à implanter à l'extérieur d'un bord de bloc, une étape de calcul de modulation de dose sur les bords dudit bloc, lesdits calculs étant liés par une relation fonctionnelle faisant intervenir la latitude en énergie du procédé, et une étape d'implantation desdits shots à l'extérieur dudit bloc.

6. Procédé de lithographie selon la revendication 5, **caractérisé en ce que** l'étape de calcul de modulation de dose sur les bords dudit bloc comprend une sous-étape de calcul de ladite dose par convolution de la dose rayonnée avec le motif du bord.

7. Procédé de lithographie selon la revendication 5, **caractérisé en ce que** l'étape de calcul de modulation de dose sur les bords dudit bloc comprend une sous-étape de calcul de ladite dose par appel d'une table de paramètres.

8. Procédé de lithographie selon l'une quelconque des revendications 6 à 7, **caractérisé en ce qu'**il comprend en outre une étape de calcul de l'au moins un espacement entre le bord du bloc et les shots à implanter à l'extérieur dudit bloc.

9. Procédé de lithographie selon l'une quelconque des revendications 1 à 8, **caractérisé en ce que** la taille d'un bloc est égale à 500 nm.

10. Programme d'ordinateur comprenant des instructions de code de programme permettant l'exécution du procédé de lithographie électronique par projection d'au moins un bloc sur un substrat résiné selon l'une des revendications 1 à 9 lorsque le programme est exécuté sur un ordinateur, ledit programme comprenant un module de fracturation dudit bloc en cellules élémentaires à projeter sur ledit substrat et un module apte à commander le formage desdites cellules par une source rayonnante.

11. Programme d'ordinateur selon la revendication 10, **caractérisé en ce qu'**il comprend en outre un module apte à effectuer le calcul de la largeur de shots à implanter à l'extérieur d'un bord de bloc et le calcul de modulation de dose sur les bords dudit bloc, lesdits calculs étant liés par une relation fonctionnelle faisant intervenir la latitude en énergie du procédé, et un module apte à réaliser l'implantation desdits shots à l'extérieur dudit bloc.

12. Programme d'ordinateur selon la revendication 10, **caractérisé en ce qu'**il comprend en outre un module apte à effectuer le calcul de l'au moins un espace entre le bord du bloc et les shots à implanter à l'extérieur dudit bloc.

## Patentansprüche

1. Elektronisches Lithografieverfahren durch Projektion von mindestens einem Block auf ein mit Harz behandeltes Substrat, beinhaltend einen Schritt des Frakturierens des Blocks in Elementarzellen (140a), welche auf das Substrat zu projizieren sind, und einen Schritt des Formens der Zellen durch eine Strahlungsquelle (110a), wobei das Verfahren **dadurch gekennzeichnet ist, dass** die Maschenweite der Elementarzellen (140a) um ungefähr 125 % größer ist als die normale Maschenweite der Zellen des Verfahrens, wobei die normale Maschenweite der Zellen des Verfahrens ungefähr 1,6 µm x 1,6 µm für die Generation der 32-45 nm-Technologie beträgt, und dadurch, dass die Dose der Strahlungsenergie einen ersten einheitlichen Wert für alle Elementarzellen des mindestens einen Blocks besitzt, ausgenommen in der Nähe der Kanten des Blocks, und einen zweiten einheitlichen Wert, welcher sich vom ersten einheitlichen Wert unterscheidet, für einen ersten Streifen, welcher sich außerhalb des Blocks befindet und von diesem durch einen Abstand getrennt ist.

2. Lithografieverfahren nach Anspruch 1, **dadurch gekennzeichnet, dass** der zweite einheitliche Wert auf einen zweiten Streifen angewandt wird, welcher vom ersten Streifen durch einen Abstand getrennt ist.

3. Lithografieverfahren nach einem der Ansprüche 1 bis 2, **dadurch gekennzeichnet, dass** mindestens eine Reihe Elementarzellen außerhalb der Kanten des zu gravierenden Blocks angeordnet ist.

4. Lithografieverfahren nach einem der Ansprüche 1 bis 3, **dadurch gekennzeichnet, dass** die nicht in der Nähe der Kanten des zu gravierenden Blocks befindlichen Elementarzellen nicht aneinander grenzen.

5. Lithografieverfahren nach einem der Ansprüche 1 bis 4, **dadurch gekennzeichnet, dass** es zudem einen Schritt des Berechnens der Breite der außerhalb einer Blockkante anzuordnenden Shots beinhaltet, einen Schritt des Berechnens der Dosismodulation an den Kanten des Blocks, wobei die Berechnungen durch eine Funktionsbeziehung verbunden sind, welche die Energiebreite des Verfahrens berücksichtigt, und einen Schritt des Anordnens der Shots außerhalb des Blocks.

6. Lithografieverfahren nach Anspruch 5, **dadurch gekennzeichnet, dass** der Schritt des Berechnens der Dosismodulation an den Kanten des Blocks einen Unterschritt des Berechnens dieser Dosis durch Einrollen der Strahlungsdosis mit dem Kantenmotiv beinhaltet.

7. Lithografieverfahren nach Anspruch 5, **dadurch gekennzeichnet, dass** der Schritt des Berechnens der Dosismodulation an den Kanten des Blocks einen Unterschritt des Berechnens dieser Dosis durch Aufrufen einer Parametertabelle beinhaltet.

8. Lithografieverfahren nach einem der Ansprüche 6 bis 7, **dadurch gekennzeichnet, dass** es zudem einen Schritt des Berechnens von mindestens einem Abstand zwischen der Kante des Blocks und den außerhalb des Blocks anzuordnenden Shots beinhaltet.

9. Lithografieverfahren nach einem der Ansprüche 1 bis 8, **dadurch gekennzeichnet, dass** die Größe eines Blocks 500 nm beträgt.

10. Computerprogramm, beinhaltend Programmcode-Befehle, die zur Ausführung des elektronischen Lithografieverfahrens durch Projektion von mindestens einem Block auf ein mit Harz behandeltes Substrat nach einem der Ansprüche 1 bis 9 dienen, wenn das Programm auf einem Computer ausgeführt wird, wobei das Programm ein Modul zum Frakturieren des Blocks in Elementarzellen beinhaltet, welche auf das Substrat zu projizieren sind, und ein Modul, welches fähig ist, das Formen der Zellen durch eine Strahlungsquelle zu steuern.

11. Computerprogramm nach Anspruch 10, **dadurch gekennzeichnet, dass** es zudem ein Modul beinhaltet, welches fähig ist, die Berechnung der Breite der außerhalb einer Blockkante anzuordnenden Shots und die Berechnung der Dosismodulation an den Kanten des Blocks vorzunehmen, wobei die Berechnungen durch eine Funktionsbeziehung verbunden sind, welche die Energiebreite des Verfahrens berücksichtigt, und ein Modul, welches fähig ist, das Anordnen der Shots außerhalb des Blocks vorzunehmen.

12. Computerprogramm nach Anspruch 10, **dadurch gekennzeichnet, dass** es zudem ein Modul beinhaltet, welches fähig ist, die Berechnung des mindestens einen Abstandes zwischen der Blockkante und den außerhalb des Blocks anzuordnenden Shots vorzunehmen.

## Claims

1. Method for electronic lithography by projection of at least one block onto a resin-treated substrate comprising a step of fracturing said block into individual cells (140a) to be projected onto said substrate and a step of forming said cells by a radiating source (110a), the method being **characterised in that** the mesh of said individual cells (140a) is greater by approximately 125% than the normal mesh of the cells of the method, the normal mesh of the cells of the method being approximately 1.6 µm x 1.6 µm for the 32-45 nm technology generation, and **in that** the dose of radiated energy has a first uniform value for all the individual cells of the at least one block, except in the vicinity of the edges of the block, and a second uniform value different from the first uniform value, for a first strip located outside the block and separated therefrom by a space.

2. Lithography method according to claim 1, **characterised in that** the second uniform value is applied to a second strip which is separated from the first strip by a space.

3. Lithography method according to either claim 1 or 2, **characterised in that** at least one row of individual cells is located outside the edges of the block to be etched.

4. Lithography method according to any one of claims 1 to 3, **characterised in that** the individual cells not located in the vicinity of the edges of the block to be etched are not contiguous.

5. Lithography method according to any one of claims 1 to 4, **characterised in that** it further comprises a step of calculating the width of shots to be located outside a block edge, a step of calculating the dose modulation on the edges of the block, the calculations being connected by a functional relationship which involves the process energy latitude of the method, and a step of locating said shots outside said block.

6. Lithography method according to claim 5, **characterised in that** the step of calculating the dose modulation on the edges of the block comprises a substep of calculating said dose by convolution of the radiated dose with the pattern of the edge.

7. Lithography method according to claim 5, **characterised in that** the step of calculating the dose modulation on the edges of said block comprises a substep of calculating said dose by invoking a table of parameters.

8. Lithography method according to either claim 6 or 7, **characterised in that** it further comprises a step of calculating the at least one spacing between the edge of the block and the shots to be located outside said block.

9. Lithography method according to any one of claims 1 to 8, **characterised in that** the size of a block is equal to 500 nm.

10. Computer program comprising program code instructions which enable the electronic lithography method by projection of at least one block onto a resin-coated substrate according to any one of claims 1 to 9 to be carried out when the program is run on a computer, the program comprising a module for fracturing said block into individual cells to be projected onto said substrate and a module capable of controlling the formation of said cells by a radiating source.

11. Computer program according to claim 10, **characterised in that** it further comprises a module capable of performing the calculation of the width of shots to be located outside a block edge and the calculation of the dose modulation on the edges of the block, the calculations being linked by a functional relationship involving the process energy latitude, and a module capable of producing the location of the shots outside said block.

12. Computer program according to claim 10, **characterised in that** it further comprises a module capable of performing the calculation of the at least one spacing between the edge of the block and the shots to be located outside said block.
